# EUROPEAN PATENT APPLICATION

(11) **EP 4 593 287 A1**
(43) Date of publication of application: **30.07.2025**
(21) Application number: 23868193.6
(22) Date of filing: 20.09.2023
(51) Int. Cl.: H03H 3/08, H03H 9/25, H01L 21/02

(54) **BONDED SUBSTRATE AND METHOD FOR MANUFACTURING BONDED SUBSTRATE**

(30) Priority: 22.09.2022 JP 2022151855
(71) Applicant: The Japan Steel Works, Ltd., Tokyo 141-0032 (JP)
(72) Inventor: MARUKO, Takuya, Tokyo 141-0032 (JP); IWATA, Hirokazu, Tokyo 141-0032 (JP); KIKUCHI, Hirokazu, Tokyo 141-0032 (JP); CHIBA, Masaki, Tokyo 141-0032 (JP); YOKOTA, Hiroaki, Tokyo 141-0032 (JP)
(74) Representative: Simmons & Simmons LLP (Munich)
(86) International application number: PCT/JP2023/034019
(87) International publication number: WO 2024/063072

(57) **Abstract**

A bonded substrate having a high bonding strength in which the formation of voids is suppressed is provided. A bonded substrate according to an aspect of the present disclosure is a bonded substrate in which a first substrate and a second substrate are bonded to each other through their bonding surfaces. The first substrate includes a first modified layer on the side thereof on which its bonding surface is located, and the second substrate includes a second modified layer on the side thereof on which its bonding surface is located. A method for manufacturing a bonded substrate according to an aspect of the present disclosure is a method for manufacturing a bonded substrate in which a first substrate and a second substrate are bonded to each other, the method including: a step of plasma-treating a surface of the first substrate and thereby forming a first modified layer over the surface of the first substrate; a step of plasma-treating a surface of the second substrate and thereby forming a second modified layer over the surface of the second substrate; a step of temporarily bonding the first and second substrates to each other in a state where the first and second modified layers face each other; and a step of annealing the temporarily-bonded substrates and thereby bonding the first and second substrates to each other.

## Description

### Technical Field

The present disclosure relates to a bonded substrate and a method for manufacturing a bonded substrate.

### Background Art

As communication apparatuses such as mobile phones have evolved, there has been a demand for the enhancement of the performance of surface acoustic wave (SAW: Surface Acoustic Wave) filters and optical modulators. For a surface acoustic wave element of which such an SAW filter is formed, it has been required, for example, to broaden the frequency band by improving the electromechanical coupling coefficient and to reduce the absolute value of the temperature coefficient of frequency (TCF: Temperature Coefficient of Frequency). Patent Literature 1 discloses a technology related to such a surface acoustic wave element. For an optical modulation element of which an optical modulator is formed, it has been required, for example, to reduce the power consumption by driving it at a lower voltage and to improve its modulation performance. Patent Literature 2 and Non-patent Literature 1 disclose technologies related to such optical modulation elements.

### Citation List

### Patent Literature

Patent Literature 1: Japanese Unexamined Patent Application Publication No. 2021-158666
Patent Literature 2: Japanese Unexamined Patent Application Publication No. 2010-85789

### Non Patent Literature

Non-patent Literature 1: Cheng Wang, Mian Zhang, Xi Chen, Maxime Bertrand, Amirhassan Shams-Ansari, Sethumadhavan Chandrasekhar, Peter Winzer & Marko Loncar "Integrated lithium niobate electro-optic modulators operating at CMOS-compatible voltages", Nature, volume 562, pages101-104 (2018)

### Summary of Invention

### Technical Problem

For example, when a surface acoustic wave element or an optical modulation element is manufactured, a bonded substrate in which a quartz substrate and a lithium tantalate substrate are bonded to each other, a bonded substrate in which two lithium niobate substrates are bonded to each other, or a bonded substrate in which a quartz substrate and a lithium niobate substrate are bonded to each other is used. However, depending on the bonding conditions of these substrates, voids may be formed in the bonding surfaces of the substrates, and/or the bonding strength between these substrates may be poor. Other problems to be solved and novel features will become apparent from the description in this specification and the accompanying drawings.

### Solution to Problem

A bonded substrate according to an aspect of the present disclosure is a bonded substrate in which a first substrate and a second substrate are bonded to each other through their bonding surfaces, in which the first substrate includes a first modified layer on a side thereof on which its bonding surface is located, and the second substrate includes a second modified layer on a side thereof on which its bonding surface is located.

A method for manufacturing a bonded substrate according to an aspect of the present disclosure is a method for manufacturing a bonded substrate in which a first substrate and a second substrate are bonded to each other, the method including: a step of plasma-treating a surface of the first substrate and thereby forming a first modified layer over the surface of the first substrate; a step of plasma-treating a surface of the second substrate and thereby forming a second modified layer over the surface of the second substrate; a step of temporarily bonding the first and second substrates to each other in a state where the first and second modified layers face each other; and a step of annealing the temporarily-bonded substrates and thereby bonding the first and second substrates to each other.

### Advantageous Effects of Invention

According to the present disclosure, it is possible to provide a bonded substrate having a high bonding strength in which the formation of voids is suppressed, and a method for manufacturing such a bonded substrate.

### Brief Description of Drawings

Fig. 1 is a cross-sectional diagram showing a bonded substrate according to an embodiment;
Fig. 2 is a flowchart for explaining a method for manufacturing a bonded substrate according to an embodiment;
Fig. 3 is a schematic diagram for explaining a method for manufacturing a bonded substrate according to an embodiment;
Fig. 4 is a graph showing a relationship between variations in plasma emission and variations in a modified layer;
Fig. 5 is a graph showing a relationship among the thickness of a modified layer of a quartz substrate, the thickness of a modified layer of a lithium tantalate substrate, a void-free region, a region where the bonding strength is satisfactory, and a region of the present disclosure;
Fig. 6 is a graph showing a relationship among the thickness of a modified layer of a quartz substrate, the thickness of a modified layer of a lithium niobate substrate, a void-free region, a region where a bonding strength is satisfactory, a plasma stable region, and a region of the present disclosure;
Fig. 7 is a graph showing a relationship among the thickness of a modified layer of a lithium niobate substrate (lower side), the thickness of a modified layer of a lithium niobate substrate (upper side), a void-free region, a region where a bonding strength is satisfactory, a plasma stable region, and a region of the present disclosure;
Fig. 8 is a photograph of a modified layer of a lithium niobate substrate taken by a transmission electron microscope (TEM);
Fig. 9 is a graph showing a luminance profile of the TEM photograph shown in Fig. 8; and
Fig. 10 is a graph showing, for each sample, a relationship between the thickness of a modified layer and a bonding strength.

### Description of Embodiments

Embodiments will be described hereinafter with reference to the drawings.

A bonded substrate according to an embodiment is a bonded substrate in which a first substrate and a second substrate are bonded to each other through their bonding surfaces. The first substrate includes a first modified layer on the side thereof on which its bonding surface is located, and the second substrate includes a second modified layer on the side thereof on which its bonding surface is located. In this embodiment, the first substrate may be a quartz substrate, and the second substrate may be a lithium tantalate substrate. Alternatively, in this embodiment, the first substrate may be a quartz substrate, and the second substrate may be a lithium niobate substrate. In another alternative, in this embodiment, the first substrate may be a first lithium niobate substrate, and the second substrate may be a second lithium niobate substrate. That is, the bonded substrate may have a structure in which two lithium niobate substrates are bonded to each other. As an example, a case where the first substrate is a quartz substrate and the second substrate is a lithium tantalate substrate will be described hereinafter.

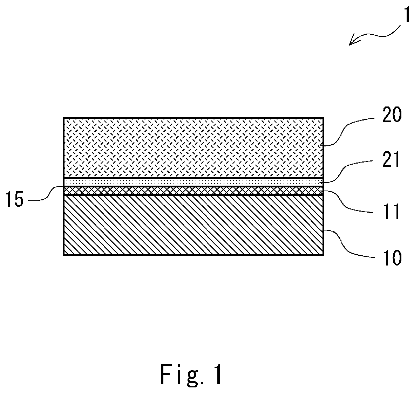

Fig. 1 is a cross-sectional diagram showing a bonded substrate according to an embodiment. As shown in Fig. 1, the bonded substrate 1 according to this embodiment is a bonded substrate in which a quartz substrate 10 and a lithium tantalate substrate 20 are bonded to each other through their bonding surfaces 15. Note that the quartz substrate (first substrate) 10 functions as a supporting substrate, and the lithium tantalate substrate (second substrate) 20 functions as a piezoelectric element.

By using the quartz substrate 10 as the supporting substrate, the frequency-temperature characteristic of the surface acoustic wave element can be improved. Further, the propagation speed of the elastic wave of lithium tantalate is high, and its electromechanical coupling coefficient is large. Therefore, it is possible to broaden the frequency band of the surface acoustic wave element by using the lithium tantalate substrate 20 as the piezoelectric element.

The quartz substrate 10 includes a modified layer 11 (first modified layer) on the side thereof on which its bonding surface 15 is located. The lithium tantalate substrate 20 includes a modified layer 21 (second modified layer) on the side thereof on which its bonding surface 15 is located. This embodiment is configured so that the modified layer 21 of the lithium tantalate substrate 20 is thinner than the modified layer 11 of the quartz substrate 10.

Specifically, in this embodiment, the thickness of the modified layer 11 of the quartz substrate 10 is larger than 2.7 nm and equal to or smaller than 3.2 nm, and preferably 2.9 nm or larger and 3.1 nm or smaller. Further, the thickness of the modified layer 21 of the lithium tantalate substrate 20 is 2.2 nm or larger and 2.7 nm or smaller, and preferably 2.4 nm or larger and 2.6 nm or smaller. In this embodiment, the modified layers 11 and 21 are amorphous layers generated by modifying the surfaces of the substrates, and can be formed by a plasma treatment, ion irradiation, or the like. Further, the modified layers 11 and 21 are amorphous layers mainly composed of the material of the underlying substrate. That is, the modified layer 11 is an amorphous layer mainly composed of the material of the quartz substrate 10. The modified layer 21 is an amorphous layer mainly composed of the material of the lithium tantalate substrate 20.

In this embodiment, the thickness of the quartz substrate 10 is 100 µm or larger and 1,000 µm or smaller, and the thickness of the lithium tantalate substrate is 10 µm or larger and 1,000 µm or smaller.

Further, in this embodiment, the surface of the lithium tantalate substrate 20 may be polished after the quartz substrate 10 and the lithium tantalate substrate 20 are bonded to each other. For example, the lithium tantalate substrate 20 may be polished to a thickness of 5 µm or smaller.

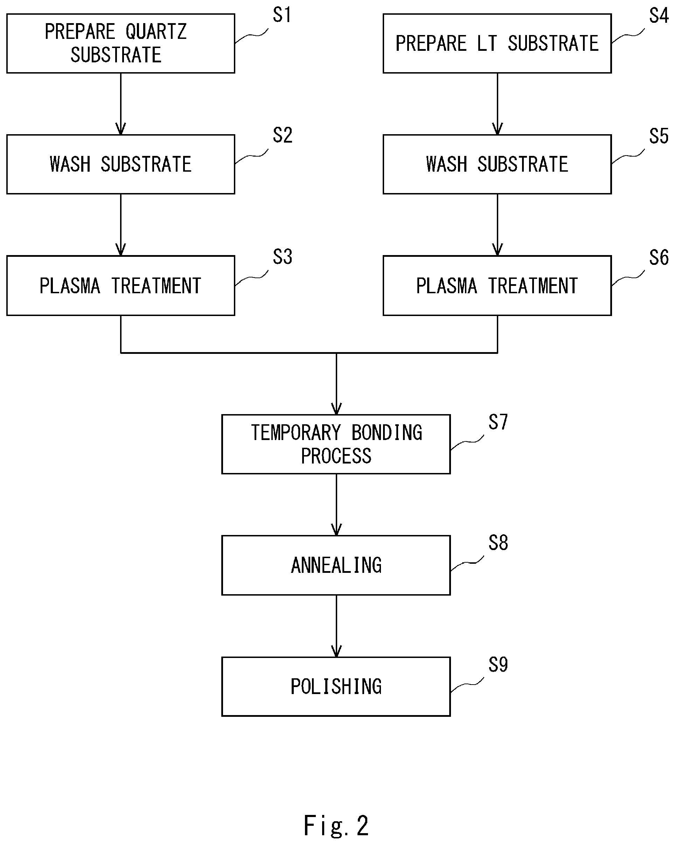

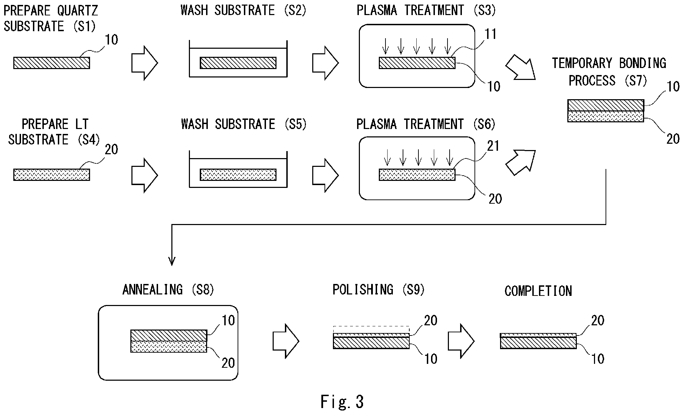

Next, a method for manufacturing a bonded substrate according to this embodiment will be described. Fig. 2 is a flowchart for explaining a method for manufacturing a bonded substrate according to this embodiment. Fig. 3 is a schematic diagram for explaining the method for manufacturing a bonded substrate according to this embodiment.

When a bonded substrate according to this embodiment is manufactured, firstly, a quartz substrate (first substrate) 10 is prepared as shown in Figs. 2 and 3 (Step S1). As an example, the thickness of the quartz substrate 10 is 100 µm or larger and 1,000 µm or smaller. Next, the quartz substrate 10 is washed (Step S2). For example, the quartz substrate 10 can be washed by using a chemical solution such as an APM (Ammonia hydrogen Peroxide Mixture) or an SPM (Sulfuric acid-hydrogen Peroxide Mixture).

Next, the quartz substrate 10 is plasma-treated (i.e., is subjected to a plasma treatment) (Step S3). It is possible to form a modified layer 11 over the surface of the quartz substrate 10 by plasma-treating the quartz substrate 10. The thickness of the modified layer 11 formed over the surface of the quartz substrate 10 is larger than 2.7 nm and equal to or smaller than 3.2 nm, and preferably 2.9 nm or larger and 3.1 nm or smaller.

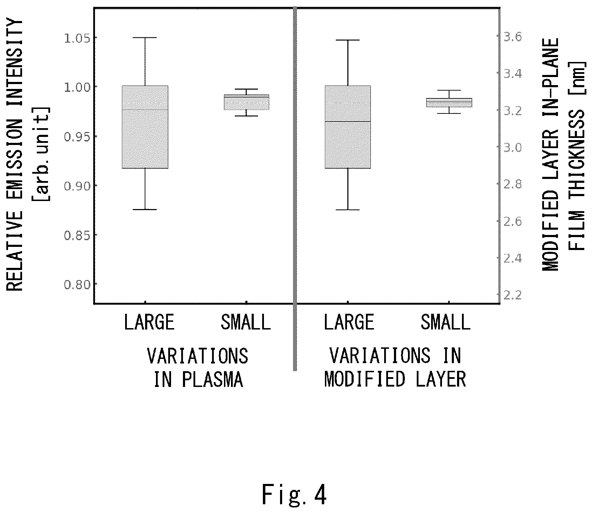

Further, in this embodiment, the quartz substrate 10 is plasma-treated under conditions in which the plasma emission is stable (conditions in which variations in plasma emission are small). Fig. 4 is a graph showing a relationship between variations in plasma emission and variations in the modified layer. As shown in Fig. 4, when variations in plasma emission are large (i.e., variations in the relative emission intensity are large), variations in the modified layer also become larger. On the other hand, when variations in plasma emission are small (i.e., variations in the relative emission intensity are small), variations in the modified layer also become smaller. In the result shown in Fig. 4, a stable region in which variations in plasma emission and variations in the modified layer can be suppressed to about 1/5 is found.

In this embodiment, variations in the in-plane film thickness of the modified layer 11 formed over the surface of the quartz substrate 10 can be reduced by plasma-treating the quartz substrate 10 under conditions in which variations in plasma emission are small. Note that variations in plasma emission can be reduced by adjusting the pressure inside the chamber of the plasma treatment apparatus and the output of plasma (RF output).

Next, a lithium tantalate substrate (LT substrate: second substrate) 20 is prepared (Step S4). As an example, the thickness of the lithium tantalate substrate 20 is 10 µm or larger and 1,000 µm or smaller. Next, the lithium tantalate substrate 20 is washed (Step S5). For example, the lithium tantalate substrate 20 can be washed by using a chemical solution such as an APM (Ammonia hydrogen Peroxide Mixture) or an SPM (Sulfuric acid-hydrogen Peroxide Mixture).

Next, the lithium tantalate substrate 20 is plasma-treated (Step S6). It is possible to form a modified layer 21 over the surface of the lithium tantalate substrate 20 by plasma-treating the lithium tantalate substrate 20. The thickness of the modified layer 21 formed over the surface of the lithium tantalate substrate 20 is 2.2 nm or larger and 2.7 nm or smaller, and preferably 2.4 nm or larger and 2.6 nm or smaller.

Further, in this embodiment, the lithium tantalate substrate 20 is plasma-treated under conditions in which the plasma emission is stable (conditions in which variations in plasma emission are small). Variations in the in-plane film thickness of the modified layer 21 formed over the surface of the lithium tantalate substrate 20 can be reduced by plasma-treating the lithium tantalate substrate 20 under conditions in which variations in plasma emission are small.

Note that the order of the processes in the steps S1 to S3 and the processes in the steps S4 to S6 may be reversed. That is, the processes in the steps S1 to S3 may be performed after performing the processes in the steps S4 to S6. Alternatively, the processes in the steps S1 to S3 and the processes in the steps S4 to S6 may be performed in parallel (simultaneously) to each other.

Next, the quartz substrate 10 and the lithium tantalate substrate 20 are temporarily bonded to each other in a state where the modified layer 11 of the quartz substrate 10 and the modified layer 21 of the lithium tantalate substrate 20 face each other (Step S7). For example, after adjusting the positions of the quartz substrate 10 and the lithium tantalate substrate 20 in the in-plane direction (i.e., the positions in the horizontal direction), the quartz substrate 10 and the lithium tantalate substrate 20 are temporarily bonded to each other by moving them in the vertical direction.

After that, the temporarily-bonded substrates are annealed, so that the quartz substrate 10 and the lithium tantalate substrate 20 bonded to each other (Step S8). By annealing them, the modified layer 11 of the quartz substrate 10 and the modified layer 21 of the lithium tantalate substrate 20 can be firmly bonded to each other, so that the quartz substrate 10 and the lithium tantalate substrate 20 can be firmly bonded to each other. For example, the temperature of the annealing is 50°C or higher and 300°C or lower. The annealing can be carried out, for example, by heating the temporarily-bonded substrates in an electric furnace.

This embodiment may further include, after bonding the quartz substrate 10 and the lithium tantalate substrate 20 to each other, a step of polishing the surface of the lithium tantalate substrate 20 (Step S9). The polishing step can be carried out, for example, by using chemical mechanical polishing (CMP: Chemical Mechanical Polishing). For example, the lithium tantalate substrate 20 is polished to a thickness of 5 µm or smaller.

It is possible to manufacture a bonded substrate according to this embodiment by using the manufacturing method (substrate bonding method) described above.

Note that in this embodiment, the thickness of the modified layer 11 of the quartz substrate 10 and the thickness of the modified layer 21 of the lithium tantalate substrate 20 can be measured by using a transmission electron microscope (TEM: Transmission Electron Microscope).

For example, it is possible to obtain the optimum conditions for the plasma treatment by measuring the thicknesses of the modified layers 11 and 21 by using a TEM and changing the conditions for the plasma treatment. Then, the modified layers 11 and 21 having thicknesses within the aforementioned range can be formed by performing the plasma treatment using the obtained optimum conditions (Steps S3 and S6).

In the case where the thicknesses of the modified layers 11 and 21 of the bonded substrate 1 are measured after bonding the quartz substrate 10 and the lithium tantalate substrate 20 to each other, a TEM is used. Further, it is possible to perform measurement in regard to the determination as to which of the substrates the modified layers 11 and 21 originate from by combining a TEM observation with an elemental analysis by EDS (Energy dispersive X-ray spectrometry). For example, it can be determined that a region where Si is contained in the modified layer is the modified layer 11 of the quartz substrate 10, and a region where Li or Ta is contained in the modified layer is the modified layer 21 of the lithium tantalate substrate 20. By using the above-described method, the thickness of each of the modified layers 11 and 21 of the bonded substrate 1 can be measured. Note that it is considered that in this embodiment, the relationship between the thicknesses of the modified layers 11 and 21 does not change after the quartz substrate 10 and the lithium tantalate substrate 20 are bonded to each other.

As described in the Background Art, when a surface acoustic wave element is manufactured, a bonded substrate in which a quartz substrate and a lithium tantalate substrate are bonded to each other is used. However, depending on the bonding conditions of these substrates, voids may be formed in the bonding surfaces of the quartz substrate and the lithium tantalate substrate, and/or the bonding strength between these substrates may be poor.

Incidentally, in general, it has been considered that the bonding strength between bonded substrates deteriorates when voids are formed in their bonding surfaces. However, as a result of the research by the inventors of the present application, it has been found that the formation of voids and the bonding strength are in a trade-off relationship. Therefore, it is difficult to achieve both the suppression of the formation of voids and the strong bonding strength at the same time.

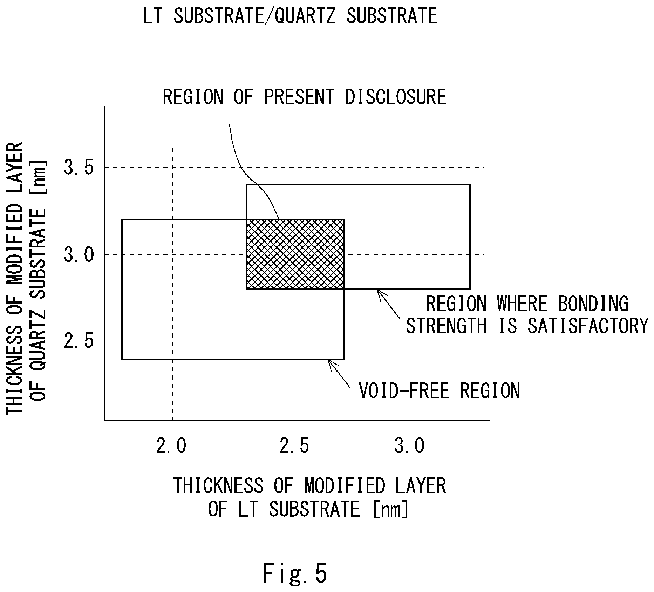

Fig. 5 is a graph showing a relationship among the thickness of a modified layer of a quartz substrate, the thickness of a modified layer of a lithium tantalate substrate, a void-free region, a region where the bonding strength is satisfactory, and a region of the present disclosure.

The inventors of the present application have found that when a quartz substrate 10 of which the thickness of the modified layer 11 is 2.4 nm or larger and 3.2 nm or smaller and a lithium tantalate substrate 20 of which the thickness of the modified layer 21 is 1.8 nm or larger and 2.7 nm or smaller are bonded to each other, there is a void-free region over the bonding surface 15 of the bonded substrate 1 in which the formation of voids can be suppressed. Note that the void-free region includes not only regions in which no voids exist at all, but also regions in which some voids are formed to the extent that they do not affect the actual use of the bonded substrate.

Further, the inventors of the present application have found that when a quartz substrate 10 of which the thickness of the modified layer 11 is 2.8 nm or larger and 3.4 nm or smaller and a lithium tantalate substrate 20 of which the thickness of the modified layer 21 is 2.3 nm or larger and 3.2 nm or smaller are bonded to each other, there is a region where the bonding strength of the bonded substrate 1 is satisfactory. Note that in this embodiment, a region where the bonding strength is 0.52 (J/m²) or higher is defined as a region where the bonding strength is satisfactory.

In consideration of the above-described relationships, the inventors of the present application have found that it is possible to obtain a bonded substrate 1 having a satisfactory bonding strength in which the formation of voids are suppressed by bonding a quartz substrate 10 of which the thickness of the modified layer 11 is larger than 2.7 nm and equal to or smaller than 3.2 nm and a lithium tantalate substrate 20 of which the thickness of the modified layer 21 is 2.2 nm or larger and 2.7 nm or smaller to each other (the region of the present disclosure shown in Fig. 5). As a result, according to the present disclosure, it is possible to provide a bonded substrate having a high bonding strength in which the formation of voids is suppressed, and a method for manufacturing such a bonded substrate. Further, it is possible to prevent bonded substrates from being separated from each other in the polishing step by increasing the bonding strength between the bonded substrates.

Further, in this embodiment, as described above with reference to Fig. 4, each of the quartz substrate 10 and the lithium tantalate substrate 20 is plasma-treated under conditions in which variations in plasma emission are small (stable conditions). Therefore, variations in the in-plane film thickness of the modified layer 11 formed over the surface of the quartz substrate 10 and those in the in-plane film thickness of the modified layer 21 formed over the surface of the lithium tantalate substrate 20 can be reduced. Therefore, it is possible to increase the bonding strength between the bonded substrates while suppressing the formation of voids.

In the above-described embodiment, as an example, the case where a quartz substrate is used as the first substrate and a lithium tantalate substrate is used as the second substrate has been described. However, in this embodiment, a quartz substrate may be used as the first substrate and a lithium niobate substrate (LN substrate) may be used as the second substrate.

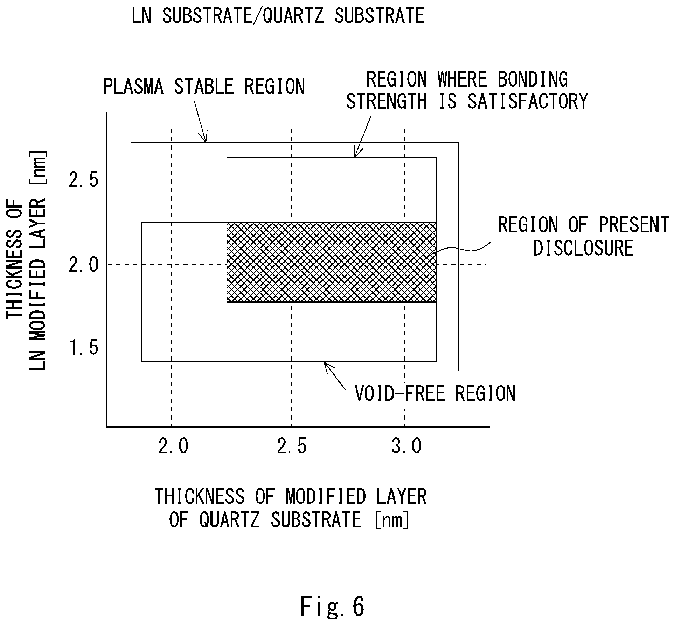

Fig. 6 is a graph showing a relationship among the thickness of a modified layer of a quartz substrate, the thickness of a modified layer of a lithium niobate substrate, a void-free region, a region where a bonding strength is satisfactory, a plasma stable region, and a region of the present disclosure. As shown in Fig. 6, when a quartz substrate and a lithium niobate substrate are bonded to each other, a bonded substrate having a satisfactory bonding strength in which the formation of voids are suppressed can be obtained by adjusting the thickness of the modified layer (first modified layer) of the quartz substrate to 2.2 nm or larger and 3.0 nm or smaller and adjusting the thickness of the lithium niobate substrate (second modified layer) to 1.75 nm or larger and 2.25 nm or smaller (the region of the present disclosure shown in Fig. 6). Note that in the graph shown in Fig. 6, a region where the bonding strength is 0.8 (J/m²) or higher is defined as a region where the bonding strength is satisfactory.

For example, the thickness of the quartz substrate is 10 µm or larger and 1,000 µm or smaller, and the thickness of the lithium niobate substrate 10 µm or larger and 1,000 µm or smaller. Further, even when a quartz substrate is used as the first substrate and a lithium niobate substrate is used as the second substrate, a bonded substrate in which the quartz substrate and the lithium niobate substrate are bonded to each other can be manufactured by using the manufacturing method (substrate bonding method) described above. **In** this case, the "lithium tantalate substrate 20" in the above-described manufacturing method is replaced with the lithium niobate substrate. Further, even in this case, the surface of the lithium niobate substrate may be polished after bonding the quartz substrate and the lithium niobate substrate to each other. For example, the surface of the lithium niobate substrate may be polished to a thickness of 10 µm or smaller. By polishing the substrate to such a thickness, the optical modulation performance of the electro-optical element can be improved.

**In** this embodiment, a first lithium niobate substrate may be used as the first substrate, and a second lithium niobate substrate may be used as the second substrate. That is, two lithium niobate substrates (LN substrates) may be bonded to each other.

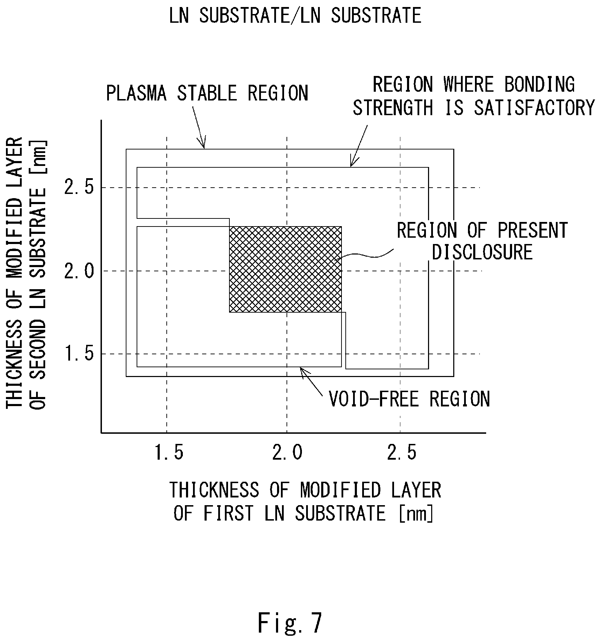

Fig. 7 is a graph showing a relationship among the thickness of a modified layer of a first lithium niobate substrate, the thickness of a modified layer of a second lithium niobate substrate, a void-free region, a region where a bonding strength is satisfactory, a plasma stable region, and a region of the present disclosure. As shown in Fig. 7, when two lithium niobate substrates are bonded to each other, it is possible to obtain a bonded substrate having a satisfactory bonding strength in which the formation of voids are suppressed by adjusting the thickness of each of the modified layers (first and second modified layers) of the respective lithium niobate substrates to 1.75 nm or larger and 2.25 nm or smaller (the region of the present disclosure shown in Fig. 7). Note that in the graph shown in Fig. 7, a region where the bonding strength is 0.8 (J/m²) or higher is defined as a region where the bonding strength is satisfactory.

For example, the thickness of the first lithium niobate substrate (first substrate: lower substrate) is 10 µm or larger and 1,000 µm or smaller, and the thickness of the second lithium niobate substrate (second substrate: upper substrate) is 10 µm or larger and 1,000 µm or smaller. Further, even when the first lithium niobate substrate is used as the first substrate and the second lithium niobate substrate is used as the second substrate, a bonded substrate in which the first and second lithium niobate substrates are bonded to each other can be manufactured by using the manufacturing method (substrate bonding method) described above. **In** this case, the "quartz substrate 10" and the "lithium tantalate substrate 20" in the above-described manufacturing method are replaced with the first lithium niobate substrate and the second lithium niobate substrate, respectively. Further, even in this case, the surface of the second lithium niobate substrate may be polished after bonding the two lithium niobate substrates (LN substrates) to each other. For example, the second lithium niobate substrate is polished to a thickness of 10 µm or smaller. By polishing the substrate to such a thickness, the optical modulation performance of the electro-optical element can be improved.

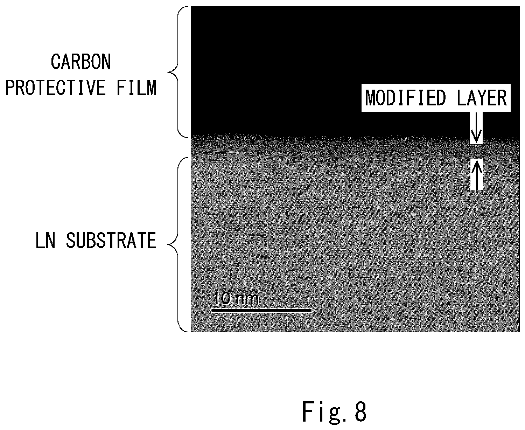

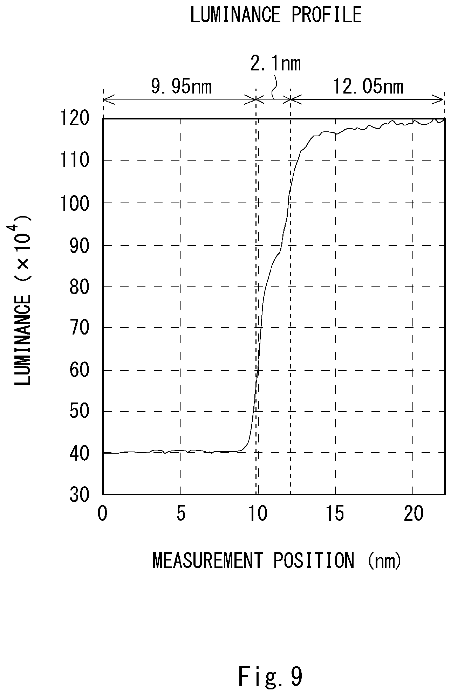

Fig. 8 is a photograph of a modified layer of a lithium niobate substrate taken by a transmission electron microscope (TEM). As shown in Fig. 8, the modified layer is formed over the surface of the lithium niobate substrate (LN substrate). Fig. 9 is a graph showing a luminance profile of the TEM photograph shown in Fig. 8. The graph shown in Fig. 9 shows measurement positions in the lithium niobate substrate and luminance at the measurement positions, and shows changes in luminance when the measurement position is moved from the carbon protective film side to the lithium niobate substrate side. As shown in Fig. 9, the luminance was low at the position of the carbon protective film, and then gradually increased at positions in the modified layer. Further, the luminance became high at the position of the lithium niobate substrate. In this embodiment, the thickness of the modified layer may be determined by using such luminance changes. In the example shown in Fig. 9, the thickness of the modified layer is 2.1 nm.

### Examples

Next, examples will be described.

A sample according to Example 1 was manufactured by using the method described above with reference to Figs. 2 and 3. Specifically, firstly, a quartz substrate having a thickness of 400 µm was prepared. Next, the quartz substrate was washed by submerging and washing it in an APM solution for 10 minutes.

Next, a modified layer having a thickness of 3.0 nm was formed over the surface of the quartz substrate by plasma-treating the quartz substrate. The plasma treatment was performed by generating capacitively-coupled plasma under a reduced-pressure atmosphere. Regarding the conditions for the plasma treatment, the RF output was set to 100 W, and the treatment time was adjusted so that the thickness of the modified layer became 3.0 nm.

Note that in this example, the substrate was plasma-treated under conditions in which the plasma emission is stable (conditions in which variations in plasma emission are small). Specifically, the plasma treatment was performed under conditions in which variations in plasma emission were small (i.e., variations in relative emission intensity were small) and variations in the modified layer were small as shown in Fig. 4. The conditions in which the plasma emission was stable was examined by adjusting the pressure inside the chamber of the plasma treatment apparatus (wafer bonding apparatus) and the output of plasma (RF output) by experimental design. Specifically, the standard deviation of the emission intensity that was obtained when 30 seconds of discharging was repeated five times was defined as variations in plasma emission. As a result, as shown in Fig. 4, variations in plasma emission were suppressed to about 1/5 as compared with the case where variations in plasma emission were large.

Further, a lithium tantalate substrate (LT substrate) having a thickness of 200 µm was prepared. Next, the lithium tantalate substrate was washed by submerging and washing it in an APM solution for 10 minutes. Next, a modified layer having a thickness of 2.5 nm was firmed over the surface of the lithium tantalate substrate by plasma-treating the lithium tantalate substrate. The plasma treatment was performed by generating capacitively-coupled plasma under a reduced-pressure atmosphere. Regarding the conditions for the plasma treatment, the RF output was set to 100 W, and the treatment time was adjusted so that the thickness of the modified layer became 2.5 nm.

Next, the quartz substrate and the lithium tantalate substrate were brought into contact with each other and thereby temporarily bonded to each other in a state where the modified layers of the quartz substrate and the lithium tantalate substrate faced each other. After that, a bonded substrate was formed by annealing the temporarily-bonded substrates at 150°C and thereby bonding the quartz substrate and the lithium tantalate substrate to each other.

Samples according to Comparative Examples 1 to 3 were manufactured by using similar methods.

In the sample according to Comparative Example 1, the thickness of the modified layer of the quartz substrate was adjusted to 3.0 nm and that of the modified layer of the lithium tantalate substrate was adjusted to 2.0 nm. In the sample according to Comparative Example 2, the thickness of the modified layer of the quartz substrate was adjusted to 3.0 nm and that of the modified layer of the lithium tantalate substrate was adjusted to 3.0 nm. In the sample according to Comparative Example 3, the thickness of the modified layer of the quartz substrate was adjusted to 2.5 nm and that of the modified layer of the lithium tantalate substrate was adjusted to 1.5 nm. The thickness of each modified layer was adjusted by changing the conditions for the plasma treatment.

For each of the samples according to Examples 1 and Comparative Examples 1 to 3 manufactured as described above, whether voids were formed or not was examined. Whether voids were formed or not was examined by using a differential interference optical microscope.

Further, the bonding strength of each of the samples according to Example 1 and Comparative Examples 1 to 3 manufactured as described above was examined. The bonding strength was measured by using a blade method. As the blade method, a method similar to the method described in a reference document (Materials Science and Engineering R25 (1999) p. 1-88) was used.

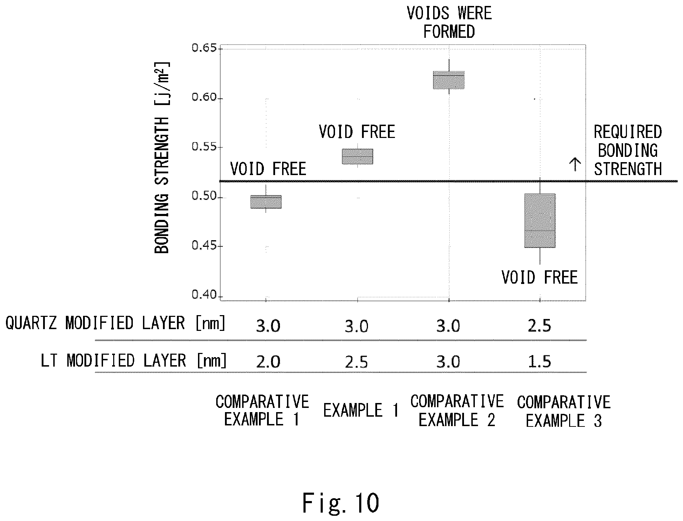

Fig. 10 is a graph showing, for each sample, a relationship between the thickness of the modified layer and the bonding strength. As shown in Fig. 10, in the sample according to Example 1, the formation of voids was suppressed and the bonding strength was equal to or higher than the reference value (0.52 (J/m²)). In contrast, in each of Comparative Examples 1 and 3, although the formation of voids was suppressed, the bonding strength was lower than the reference value. In Comparative Example 2, although the bonding strength was equal to or higher than the reference value, voids were formed.

From the results described above, in the sample according to Example 1, in which the thickness of the modified layer of the quartz substrate was 3.0 nm and the thickness of the modified layer of the lithium tantalate substrate was 2.5 nm, the bonding strength equal to or higher than the reference value was achieved and the formation of voids were suppressed.

The invention made by the inventors of the present application has been described above in a concreate manner based on the embodiments. However, needless to say, the invention is not limited to the embodiments described above, and various modifications can be made without departing from the scope and spirit of the invention.

This application is based upon and claims the benefit of priority from Japanese Patent Application 2022-151855, filed on September 22, 2022, the disclosure of which is incorporated herein in its entirety by reference.

### Reference Signs List

- 1: BONDED SUBSTRATE
- 10: QUARTZ SUBSTRATE
- 11: MODIFIED LAYER
- 15: BONDING SURFACE
- 20: LITHIUM TANTALATE SUBSTRATE
- 21: MODIFIED LAYER

## Claims

1. A bonded substrate in which a first substrate and a second substrate are bonded to each other through their bonding surfaces, wherein
the first substrate comprises a first modified layer on a side thereof on which its bonding surface is located, and
the second substrate comprises a second modified layer on a side thereof on which its bonding surface is located.

2. The bonded substrate according to claim 1, wherein
the first substrate is a quartz substrate, and
the second substrate is a lithium tantalate substrate.

3. The bonded substrate according to claim 2, wherein
a thickness of the first modified layer is larger than 2.7 nm and equal to or smaller than 3.2 nm, and
a thickness of the second modified layer is 2.2 nm or larger and 2.7 nm or smaller.

4. The bonded substrate according to claim 2, wherein
a thickness of the quartz substrate is 100 µm or larger and 1,000 µm or smaller, and
a thickness of the lithium tantalate substrate is 10 µm or larger and 1,000 µm or smaller.

5. The bonded substrate according to claim 1, wherein
the first substrate is a quartz substrate; and
the second substrate is a lithium niobate substrate.

6. The bonded substrate according to claim 5, wherein
a thickness of the first modified layer is 2.2 nm or larger and 3.0 nm or smaller, and
a thickness of the second modified layer is 1.75 nm or larger and 2.25 nm or smaller.

7. The bonded substrate according to claim 1, wherein
the first substrate is a first lithium niobate substrate, and
the second substrate is a second lithium niobate substrate.

8. The bonded substrate according to claim 7, wherein
a thickness of the first modified layer is 1.75 nm or larger and 2.25 nm or smaller; and
a thickness of the second modified layer is 1.75 nm or larger and 2.25 nm or smaller.

9. A method for manufacturing a bonded substrate in which a first substrate and a second substrate are bonded to each other, the method comprising the steps of:
plasma-treating a surface of the first substrate and thereby forming a first modified layer over the surface of the first substrate;
plasma-treating a surface of the second substrate and thereby forming a second modified layer over the surface of the second substrate;
temporarily bonding the first and second substrates to each other in a state where the first and second modified layers face each other; and
annealing the temporarily-bonded substrates and thereby bonding the first and second substrates to each other.

10. The method for manufacturing a bonded substrate according to claim 9, wherein
the first substrate is a quartz substrate,
the second substrate is a lithium tantalate substrate, and
the second modified layer is thinner than the first modified layer.

11. The method for manufacturing a bonded substrate according to claim 10, wherein
a thickness of the first modified layer is larger than 2.7 nm and equal to or smaller than 3.2 nm.
a thickness of the second modified layer is 2.2 nm or larger and 2.7 nm or smaller.

12. The method for manufacturing a bonded substrate according to claim 10, wherein a temperature of the annealing is 50°C or higher and 300°C or lower.

13. The method for manufacturing a bonded substrate according to claim 10, wherein
a thickness of the quartz substrate is 100 µm or larger and 1,000 µm or smaller, and
a thickness of the lithium tantalate substrate is 10 µm or larger and 1,000 µm or smaller.

14. The method for manufacturing a bonded substrate according to claim 10, further comprising, after bonding the quartz substrate and the lithium tantalate substrate to each other, a step of polishing a surface of the lithium tantalate substrate on a side thereof opposite to a side on which the second modified layer is formed.

15. The method for manufacturing a bonded substrate according to claim 14, wherein the lithium tantalate substrate is polished to a thickness of 5 µm or smaller.

16. The method for manufacturing a bonded substrate according to claim 9, wherein
the first substrate is a quartz substrate, and
the second substrate is a lithium niobate substrate.

17. The method for manufacturing a bonded substrate according to claim 16, wherein
a thickness of the first modified layer is 2.2 nm or larger and 3.0 nm or smaller, and
a thickness of the second modified layer is 1.75 nm or larger and 2.25 nm or smaller.

18. The method for manufacturing a bonded substrate according to claim 16, wherein a temperature of the annealing is 50°C or higher and 300°C or lower.

19. The method for manufacturing a bonded substrate according to claim 16, wherein
a thickness of the quartz substrate is 100 µm or larger and 1,000 µm or smaller, and
a thickness of the lithium niobate substrate is 10 µm or larger and 1,000 µm or smaller.

20. The method for manufacturing a bonded substrate according to claim 16, further comprising, after bonding the quartz substrate and the lithium niobate substrate to each other, a step of polishing a surface of the lithium niobate substrate on a side thereof opposite to a side on which the second modified layer is formed.

21. The method for manufacturing a bonded substrate according to claim 20, wherein the lithium niobate substrate is polished to a thickness of 10 µm or smaller.

22. The method for manufacturing a bonded substrate according to claim 9, wherein
the first substrate is a first lithium niobate substrate, and
the second substrate is a second lithium niobate substrate.

23. The method for manufacturing a bonded substrate according to claim 22, wherein
a thickness of the first modified layer is 1.75 nm or larger and 2.25 nm or smaller; and
a thickness of the second modified layer is 1.75 nm or larger and 2.25 nm or smaller.

24. The method for manufacturing a bonded substrate according to claim 22, wherein a temperature of the annealing is 50°C or higher and 300°C or lower.

25. The method for manufacturing a bonded substrate according to claim 22, wherein
a thickness of the first substrate is 100 µm or larger and 1,000 µm or smaller, and
a thickness of the second substrate is 10 µm or larger and 1,000 µm or smaller.

26. The method for manufacturing a bonded substrate according to claim 22, further comprising, after bonding the first and second substrates to each other, a step of polishing a surface of the second substrate on a side thereof opposite to a side on which the second modified layer is formed.

27. The method for manufacturing a bonded substrate according to claim 26, wherein the second substrate is polished to a thickness of 10 µm or smaller.
